# EUROPEAN PATENT APPLICATION

(11) **EP 2 562 833 A1**
(43) Date of publication of application: **27.02.2013**
(21) Application number: 11771934.4
(22) Date of filing: 14.04.2011
(51) Int. Cl.: H01L 33/64, H01L 33/62, H01S 5/022, H01S 5/40

(54) **LIGHT-EMITTING DEVICE**

(30) Priority: 18.03.2011 JP 2011060639; 19.04.2010 JP 2010096226
(71) Applicant: Harison Toshiba Lighting Corp., Imabari-shi Ehime 794-8510 (JP)
(72) Inventor: KINOSHITA, Junichi, Imabari-shi Ehime 794-8510 (JP); TAKEDA, Yuji, Imabari-shi Ehime 794-8510 (JP); WADA, Naoki, Imabari-shi Ehime 794-8510 (JP); TAKAGI, Masami, Imabari-shi Ehime 794-8510 (JP); ARAI, Toshiyuki, Imabari-shi Ehime 794-8510 (JP); NAKAMURA, Hirozumi, Imabari-shi Ehime 794-8510 (JP); TOYODA, Naoki, Imabari-shi Ehime 794-8510 (JP); KAWASAKI, Yoji, Imabari-shi Ehime 794-8510 (JP); UENO, Misaki, Imabari-shi Ehime 794-8510 (JP)
(74) Representative: HOFFMANN EITLE
(86) International application number: PCT/JP2011/059312
(87) International publication number: WO 2011/132599

(57) **Abstract**

According to one embodiment, a light emitting device includes first and second plate electrodes, a light emitting element and an insulator. The first plate electrode includes first and second major surfaces. The second plate electrode includes third and fourth major surfaces. The light emitting element is placed between the first surface and third major surfaces. The light emitting element includes a semiconductor stacked body having a fifth major surface and a sixth major surface, a first electrode and a second electrode. The semiconductor stacked body includes a light emitting layer. Optical axis is made perpendicular to a side surface of the semiconductor stacked body. The insulator is provided in contact with the first and second plate electrodes and including a window. The light beam is enabled to pass through the window and to be emitted outward.

## Description

### [Technical Field]

This invention relates to a light emitting device.

### [Background Art]

In a surface light-emitting element, electrodes are provided on the upper surface and the lower surface, and part of the emission light is blocked by the electrode on the upper surface or the lower surface. Furthermore, heat conductive path to a heatsink to escape eventually into ambient is limited to the lower surface side. This results in poor heat management, and it is difficult to increase current density. Thus, higher brightness requires a chip with larger area.

Furthermore, the surface light-emitting element has a Lambertian radiation pattern, having a full width at half maximum of as wide as e.g. 120 degrees. Thus, it is difficult to focus the emission light on a small area with a narrow divergence.

In contrast, an edge emitting type semiconductor laser (diode laser, laser diode, LD) can emit a light beam with sharp directivity from a minute point on the side surface (waveguide edge). Thus, LDs are applied to e.g. optical disc drive such as CD/DVD/Blue-ray, and high speed fiber optic equipment. In this case, the light beam is optically narrowed to a minute spot. Thus, the LDs must operate in a single transverse mode for reading a minute spot and coupling to an optical fiber. Thus, it is necessary to use expensive optical components.

Such an LD having a light beam with a very narrow divergence is applicable to a linear light source. In the linear light source, for instance, the light beam from the LD is incident into an end of a light guide. While being guided along the light guide, the light is reflected at the lower surface, and emitted toward the upper surface. A luminescent body absorbs this emission light beam and can emit visible light. Such a linear light source can be used for e.g. an automobile fog lamp and a backlight source of a display device. Furthermore, an LD is also applicable as a scanning light source. For instance, it can be used for a projection display device scanning a light beam. In the case of linear light sources and scanning light sources, LD may be used in a multiple transverse mode operation. Thus, the optical system does not need to be so minute.

Such applications as linear light sources and projection type display devices require a light emitting device using a small package with high thermal conductivity, high assembly performance, and high mass productivity.

Patent Document 1 discloses an LED with good productivity and no degradation in light emission characteristics. In this example, the LED (light emitting diode) chip is sandwiched between a pair of lead portions. Furthermore, a glass material encloses the LED chip in a non-contact manner.

### [Citation List]

### [Patent Literature]

[PTL1] JP-A 2005-333014(Kokai)

### [Summary of Invention]

### [Technical Problem]

This invention provides a light emitting device having improved heat conductivity and being easy to assemble on e.g. illumination devices.

### [Solution to Problem]

In general, according to one embodiment, a light emitting device includes a first plate electrode, a second plate electrode, a light emitting element and an insulator. The first plate electrode includes a first major surface and a second major surface on an opposite side of the first major surface. The second plate electrode includes a third major surface and a fourth major surface on an opposite side of the third major surface. The light emitting element is placed between the first major surface and the third major surface. The light emitting element includes a semiconductor stacked body having a fifth major surface facing the first major surface and being smaller than the first major surface and a sixth major surface facing the third major surface and being smaller than the third major surface, a first electrode provided on the fifth major surface and a second electrode provided on the sixth major surface. The semiconductor stacked body includes a light emitting layer. Optical axis of a light beam emitted from the light emitting layer is made perpendicular to a side surface of the semiconductor stacked body between the fifth major surface and the sixth major surface. The insulator is provided in contact with the first plate electrode and the second plate electrode and including a window formed on the optical axis. The light beam is enabled to pass through the window and to be emitted outward.

### [Advantageous Effects of Invention]

A light emitting device having improved heat dissipation and being easy to mount on e.g. illumination devices is provided.

### [Brief Description of Drawings]

[FIG. 1] FIG. 1A is a schematic perspective view of a light emitting device according to a first embodiment of the invention. FIG. 1B is a schematic perspective view of a light emitting element used therein.
[FIG. 2] FIGS. 2A to 2D are schematic perspective views describing a process for assembling the light emitting device.
[FIG. 3] FIGS. 3A and 3B are schematic sectional views of the adhesion structure of the plate electrodes and the insulator.
[FIG. 4] FIGS. 4A and 4B are schematic sectional views showing the emission direction of the light beam.
[FIG. 5] FIG. 5A is a schematic sectional view of a light emitting device according to a second embodiment. FIGS. 5B and 5C are schematic sectional views of variations thereof.
[FIG. 6] FIG. 6A is a schematic view of a light emitting device according to a third embodiment. FIG. 6B is a schematic sectional view.
[FIG. 7] FIG. 7A is a schematic perspective view of a light emitting device according to a fourth embodiment. FIG. 7B is a schematic sectional view taken along line A-A.
[FIG. 8] FIGS. 8A and 8B are schematic perspective views of a light emitting device according to a fifth embodiment.
[FIG. 9] FIGS. 9A to 9E are schematic views of a light emitting device according to a sixth embodiment.
[FIG. 10] FIGS. 10A to 10F are schematic perspective views of a light emitting device according to a seventh embodiment.
[FIG. 11] FIG. 11 is a schematic sectional view of a linear light source using the light emitting device according to this embodiment.
[FIG. 12] FIG. 12A is a schematic perspective view of a light emitting device according to an eighth embodiment. FIG. 12B is a schematic sectional view taken along line B-B. FIG. 12C is a schematic sectional view of a first variation. FIG. 12D is a schematic sectional view of a second variation.
[FIG. 13] FIG. 13A is a schematic perspective view of a light emitting device according to a ninth embodiment. FIG. 13B is a schematic perspective view of a light emitting device according to a variation thereof.
[FIG. 14] FIG. 14A is a schematic perspective view of a light emitting device according to a tenth embodiment. FIG. 14B is a schematic sectional view taken along line B-B. FIG. 14C is a schematic sectional view taken along line C-C. FIG. 14D is a schematic sectional view of a first variation thereof. FIG. 14E is a schematic sectional view of the first variation taken along line C-C. FIG. 14F is a schematic sectional view of a second variation. FIG. 14G is a schematic sectional view of the second variation taken along line C-C.
[FIG. 15] FIG. 15A is a schematic sectional view of a linear light emitting illumination device using the light emitting device according to the eighth embodiment. FIG. 15B is a schematic sectional view of a linear light emitting illumination device using the light emitting device according to the first variation of the eighth embodiment. FIG. 15C is a schematic sectional view of a linear light emitting illumination device using the light emitting device according to the tenth embodiment.
[FIG. 16] FIG. 16A is a schematic perspective view of a light emitting device according to an eleventh embodiment. FIG. 16B is a schematic perspective view of a linear light emitting illumination device.

### [Description of Embodiments]

Embodiments of the invention will now be described with reference to the drawings.

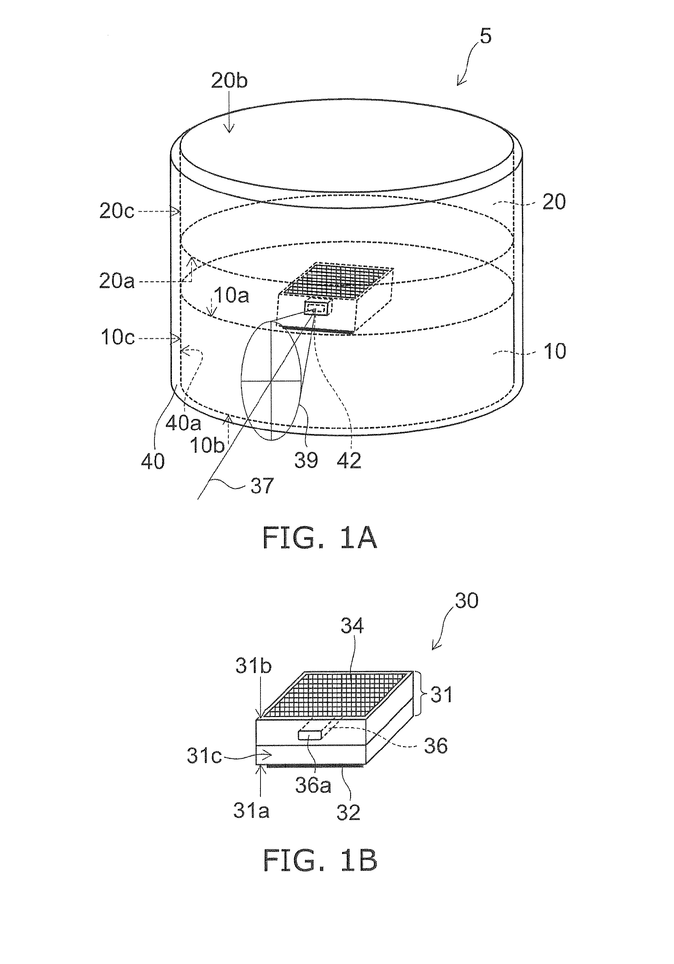

FIG. 1A is a schematic perspective view of a light emitting device according to a first embodiment of the invention. FIG. 1B is a schematic perspective view of a light emitting element used therein.

The light emitting device 5 includes a first plate electrode 10, a second plate electrode 20, a light emitting element 30 sandwiched between the first plate electrode 10 and the second plate electrode 20, and an insulator 40 in contact with the first plate electrode 10 and the second plate electrode 20.

The first plate electrode 10 made of a metal includes a first major surface 10a and a second major surface 10b on the opposite side of the first major surface 10a. The second plate electrode 20 made of a metal includes a third major surface 20a and a fourth major surface 20b on the opposite side of the third major surface 20a.

The light emitting element 30 includes a semiconductor stacked body 31 including a light emitting layer 36, a first electrode 32, and a second electrode 34. The first electrode 32 is provided on a fifth major surface 31a of the semiconductor stacked body 31. The fifth major surface 31a faces the first major surface 10a of the first plate electrode 10 and is smaller than the first major surface 10a. The second electrode 34 is provided on a sixth major surface 31b of the semiconductor stacked body 31. The sixth major surface 31b faces the third major surface 20a of the second plate electrode 20 and is smaller than the third major surface 20a. That is, the light emitting element 30 is sandwiched between the first major surface 10a of the first plate electrode 10 and the third major surface 20a of the second plate electrode 20. By applying a forward voltage between the second major surface 10b of the first plate electrode 10 and the fourth major surface 20b of the second plate electrode 20, the light emitting element 30 can emit light.

Furthermore, the light emitting element 30 includes four side surfaces between the fifth major surface 31a and the sixth major surface 31b. The end portion 36a of the light emitting layer 36 constitutes part of one side surface 31c of the side surfaces of the semiconductor stacked body 31. The light emitting layer 36 has an optical axis 37 in the direction perpendicular to the side surface 31c. If the light emitting element 30 is an edge emitting type LD or LED, the intensity of its emission light (light beam) is maximized on the optical axis 37. However, the intensity is very low on the side of the fifth major surface 31a and the sixth major surface 31b of the semiconductor stacked body 31 spaced from the optical axis 37. Here, in the edge emitting type LD or LED, two opposed end faces constitute an optical resonator. In this case, for instance, the light reflectance at the front surface used as a light emitting surface is set to 20% or less. The light reflectance at the rear surface used as a light reflecting surface is set to 90% or more. Then, on the light reflecting surface side, a higher optical output can be obtained.

The insulator 40 is provided in contact with the first plate electrode 10 and the second plate electrode 20. Specifically, the insulator 40 is provided in contact with the first major surface 10a and the second major surface 10b, or the outer edge 10c of the first plate electrode 10 and the outer edge 20c of the second plate electrode 20. The light beam 39 can be emitted through a window to the outside of the outer edges 10c, 20c. That is, the light beam 39 is emitted outward from between the first major surface 10a and the third major surface 20a. The insulator 40 can be made of e.g. low melting point glass based on SiO₂ and B₂O₃, resin, or ceramic. Thus, the insulator 40 is provided in contact with the outer edge 10c of the first plate electrode 10 and the outer edge 20c of the second plate electrode 20. The insulator 40 is made of e.g. a glass or transparent resin layer. Then, the light beam 39 passes through the interior of the insulator 40 and is emitted outward. Furthermore, the insulator 40 may be provided in contact with the first major surface 10a and the second major surface 20a. Also in the case, the light beam 39 can be emitted outward without being blocked by the insulator 40.

A forward voltage is applied to the pn junction of the light emitting element 30. Thus, holes and electrons are injected into the light emitting layer 36. Then, radiative recombination occurs. Heat generated at the pn junction is dissipated from the first and second plate electrodes 10, 20. The first and second plate electrodes 10, 20 are larger than the fifth and sixth major surfaces 31a, 31b of the light emitting element 30. This reduces thermal resistance to the external heatsink and radiation fins.

The first and second plate electrodes 10, 20 can be shaped like e.g. a disc, rectangle, or polygon. In this case, as viewed from above, the positions of the respective centers may be aligned. This simplifies the assembly process. Furthermore, for instance, the plate electrodes may be shaped like discs having aligned center positions and an equal diameter. This facilitates adjusting the emission direction of the light beam 39 by rotating the light emitting device about the center of the plate electrodes. Furthermore, this facilitates e.g. the mount process of the light emitting device and the assembly process on an illumination device.

Typically, for the LD of an optical disc drive, for instance, a CAN package having a diameter of 5.6 mm is used. For electrical connection, the CAN package has metal leads with a diameter of 0.45 mm. Thus, heat generated at the pn junction is primarily dissipated from the thin lead. This results in large temperature increase at the pn junction. Furthermore, attachment to the PCB and alignment of the light emission direction are not easy. Moreover, the productivity of the manufacturing process for the discrete CAN packages is not high enough, and more cost reduction is difficult. In contrast, in this embodiment, the package structure is much simpler, the heat conductivity is improved, and assembly on the PCB is much easier. Furthermore, the productivity of the manufacturing process for the CAN light emitting device can be increased. This results in easy cost reduction.

The light emitting element 30 is made of e.g. an InGaAIN-based, InAlGaP-based, or GaAlAs-based material, and configured as an edge emitting type LD or LED.
In this specification, the InGaAIN-based material is represented by the composition formula InₓGa_{y}Al_{1-x-y}N (0≤x≤1, 0≤y≤1) and may contain an element serving as an acceptor or donor. The material is represented by the composition formula Inₓ(Al_{y}Ga_{1-y})₁₋ₓP (0≤x≤1, 0≤y≤1) and may contain an element serving as an acceptor or donor. The AlGaAs-based material is represented by the composition formula AlₓGa₁₋ₓAs (0≤x≤1) and may contain an element serving as an acceptor or donor.

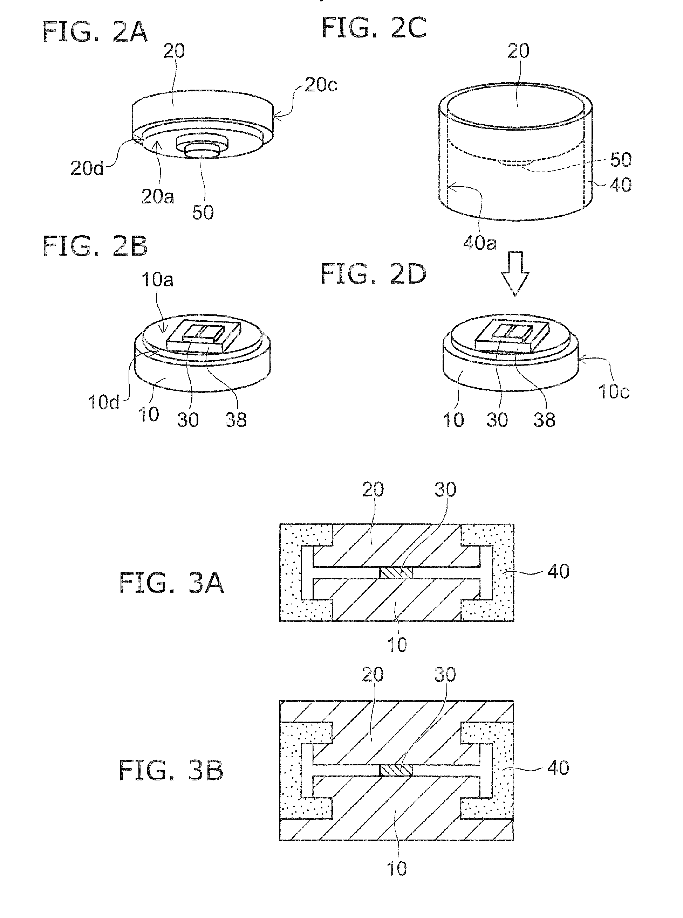

FIGS. 2A to 2D are schematic perspective views describing a process for assembling the light emitting device.
As shown in FIG. 2A, on the third major surface 20a of the second plate electrode 20, a metal bump 50 made of a solder ball or Au ball is formed. It may be a ball formed by e.g. electrical discharge at the tip of an Au bonding wire. Use of the metal bump 50 eliminates the need of high accuracy as in the wire bonding process. This facilitates the assembling process. Furthermore, this facilitates relaxing mechanical stress between the light emitting element 30 and the first or second plate electrode 10, 20. Here, the first and second plate electrodes 10, 20 can be made of e.g. copper, FeNi-based Kovar metal, or Dumet wire (copper-coated nickel steel wire).

On the other hand, as shown in FIG. 2B, using e.g. an adhesive or solder material, the light emitting element 30 is bonded to the first major surface 10a of the first plate electrode 10 via a submount 38. In this case, the light emitting element 30 may be first bonded to the submount 38. Alternatively, the submount 38 may be bonded to the first plate electrode 10, and then the light emitting element 30 may be bonded onto the submount 38. Here, it is also possible to bond the light emitting element 30 to the first plate electrode 10 without the intermediary of the submount 38. However, use of the submount 38 made of a ceramic such as AlN and Al₂O₃ can reduce the stress produced by the difference between the thermal expansion coefficient of the first plate electrode 10 or the second plate electrode 20 and the thermal expansion coefficient of the light emitting element 30. Thus, the reliability is improved.

Subsequently, as shown in FIG. 2C, the second plate electrode 20 is bonded to the insulator 40 made of e.g. glass or ceramic. In this case, for instance, the laser sealing process may be used. This facilitates tightly sealing the outer edge 20c of the second plate electrode 20 and the inner edge 40a of the insulator 40.

Furthermore, as shown in FIG. 2D, the insulator 40 is brought close to the first plate electrode 10 until the metal bump 50 is reliably brought into contact with the second electrode 34 of the light emitting element 30. With the first plate electrode 10 and the second plate electrode 20 kept at prescribed positions, the outer edge 10c of the first plate electrode 10 and the inner edge 40a of the insulator 40 are tightly sealed by using e.g. the laser sealing process.

In the case where the wavelength of the light beam 39 from the light emitting element 30 is in the wavelength range from ultraviolet to blue-violet light, the light beam 39 has high photon energy. Then, organic matters are likely to be decomposed and deposit them to the light emitting end face. However, the insulator 40 such as glass is used for sealing, and the inside is filled with e.g. inert gas, dry nitrogen, or dry air. This can suppress contamination with organic matter from the outside and suppress the degradation of the light emitting element 30. Thus, the long-term reliability can be improved.

Furthermore, the first major surface 10a of the first plate electrode 10 may be provided with a notch-shaped groove 10d. This can reduce "blocking" of the light beam 39 by the first major surface 10a. Likewise, the third major surface 20a of the second plate electrode 20 may be provided with a groove 20d. This can reduce blocking by the third major surface 20a. Here, "blocking" means that a part of the light beam 39 irradiates the first or second plate electrode 10, 20 and, due to reflection, fails to travel to a desired direction.

FIGS. 3A and 3B are schematic sectional views of the adhesion structure of the plate electrodes and the insulator.
In FIG. 3A, the first and second plate electrodes 10, 20 are provided with a down-step and bonded to the insulator 40 made of e.g. glass. In FIG. 3B, the first and second plate electrodes 10, 20 are bonded so as to cover the end face of the glass. Thus, between the plate electrodes and the glass, the adhesion strength can be increased.

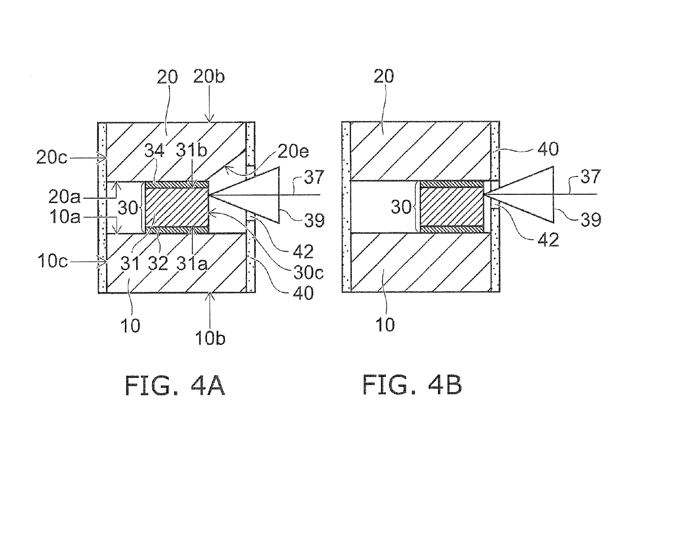

FIGS. 4A and 4B are schematic sectional views showing the emission direction of the light beam.
The spread angle of the light beam 39 of an edge emitting type LD or LED is easily made narrower than that of a surface light-emitting element. However, in the case of LD, for instance, the beam divergence angle (full width at half maximum) in the direction perpendicular to the fifth and sixth major surfaces 31a, 31b is in the range of e.g. 20-50 degrees. As shown in FIG. 4A, for instance, the third major surface 20a of the second plate electrode 20 may be obliquely cut (20e). This can reduce "blocking" of the light beam 39 by the first or second plate electrode 10, 20. Here, even if the insulator 40 is made of a light blocking material, a window 42 made of a transparent material allowing passage of the light beam 39 can be provided along the optical axis 37. If the insulator 40 is made of a transparent material such as glass, the region along the optical axis functions as a window.

Alternatively, as shown in FIG. 4B, the light emitting element 30 may be biased to the outer edge 10c, 20c side on the first major surface 10a of the first plate electrode 10 and the third major surface 20a of the second plate electrode 20. This can also reduce "blocking" of the light beam 39 by the first and second plate electrodes 10, 20.

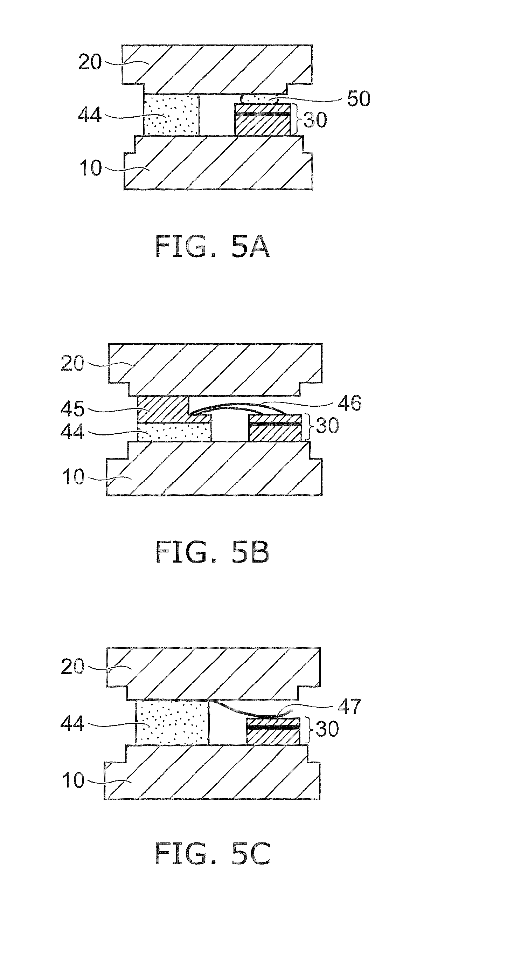

FIG. 5A is a schematic sectional view of a light emitting device according to a second embodiment. FIGS. 5B and 5C are schematic sectional views of variations thereof.
As shown in FIG. 5A, in the space on the other side (left) of the light emitting element 30 which is mounted on the off-centered position (on the right side), a second insulator 44 is provided in contact with the first and second plate electrodes 10, 20. That is, the first and second plate electrodes 10, 20 are each provided in contact with the second insulator 44. In this case, the height of the second insulator 44 may be made larger than the height of the light emitting element 30. A metal bump 50 such as a solder ball and gold ball may be provided in at least one of the gap between the first electrode 32 of the light emitting element 30 and the first plate electrode 10, and the gap between the second electrode 34 of the light emitting element 30 and the second plate electrode 20. Here, the insulator 44 may be shaped like an annulus, and the light emitting element 30 may be provided therein. Then, while relaxing the thermal and mechanical stress, reliable electrical connection can be maintained, and thermal conduction can be improved. Here, the outer edge 10c of the first plate electrode 10 and the outer edge 20c of the second plate electrode 20 may be bonded to the inner edge 40a of the insulator 40 and sealed. This can further enhance the reliability of the light emitting device.

In the variation of FIG. 5B, a stepped metal body 45 is placed between the insulator 44 and the second plate electrode 20. The stepped surface and the electrode of the light emitting element 30 can be connected by a bonding wire 46. Instead of the metal body 45, an insulator provided with a conductive layer on its surface by e.g. plating can be used. In the variation of FIG. 5C, a conductive plate 47 is sandwiched between the insulator 44 and the second plate electrode 20. By the bending elasticity of the conductive plate 47, electrical connection can be maintained while pressing the light emitting element 30.

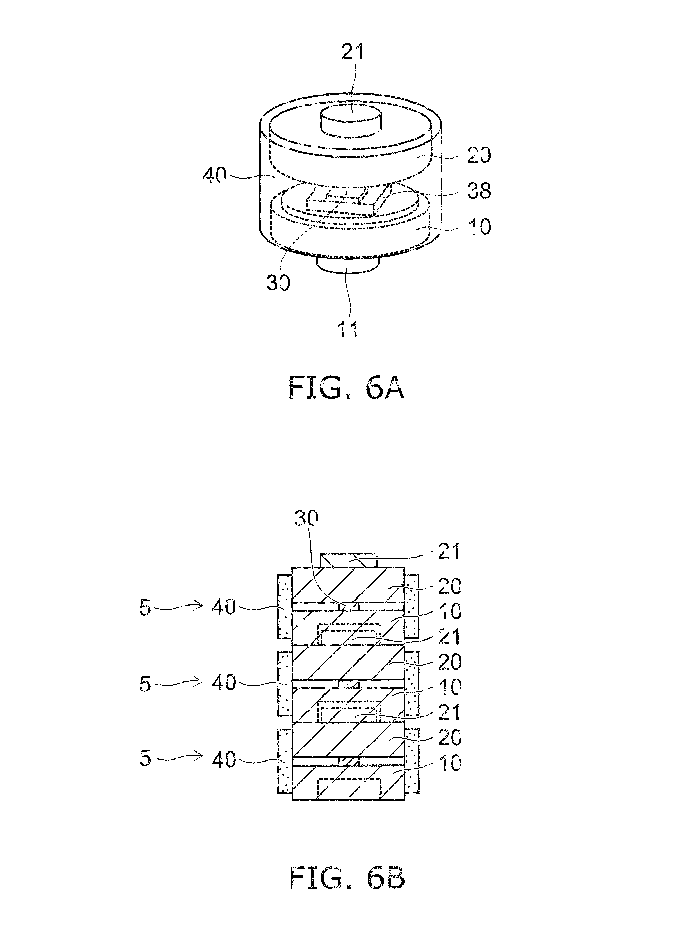

FIG. 6A is a schematic view of a light emitting device according to a third embodiment. FIG. 6B is a schematic sectional view.
In FIG. 6A, the first plate electrode 10 includes a protrusion 11 on the second major surface 10b. The second plate electrode 20 includes a protrusion 21 on the fourth major surface 20b. The protrusions 11, 21 can be reliably fixed to and brought into contact with each attached target side by providing a recess thereon. In FIG. 6B, the second major surface 10b is provided with a recess, and the fourth major surface 20b is provided with a protrusion 21. The recess and the protrusion are fitted together. Thus, three light emitting devices 5 are series connected. The number of series connection is not limited to three. Increasing the number facilitates obtaining a light beam 39 with higher output. Here, the protrusion and the recess can be shaped like a circle. Then, they can be rotated in the fitted state to change the emission direction of the light beam. Alternatively, the protrusion and the recess can be shaped like a polygon. This facilitates fixing the emission direction of the light beam.

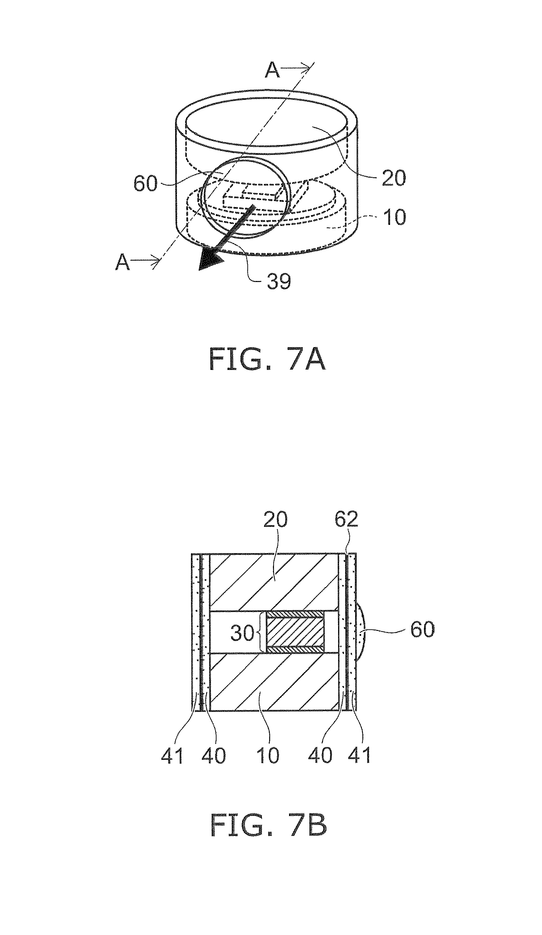

FIG. 7A is a schematic perspective view of a light emitting device according to a fourth embodiment. FIG. 7B is a schematic sectional view taken along line A-A.
The insulators 40, 41 may include a lens 60 on the emission side of the light beam 39. For instance, the lens 60 may be a convex lens. Then, the light beam 39 can be converged to a minute spot. Such a lens can be integrally molded with the insulators 40, 41 made of e.g. glass or transparent resin. Furthermore, a anti-reflective coating layer 62 may be provided between the insulators 40, 41. This can further increase the light extraction efficiency of the light beam 39.

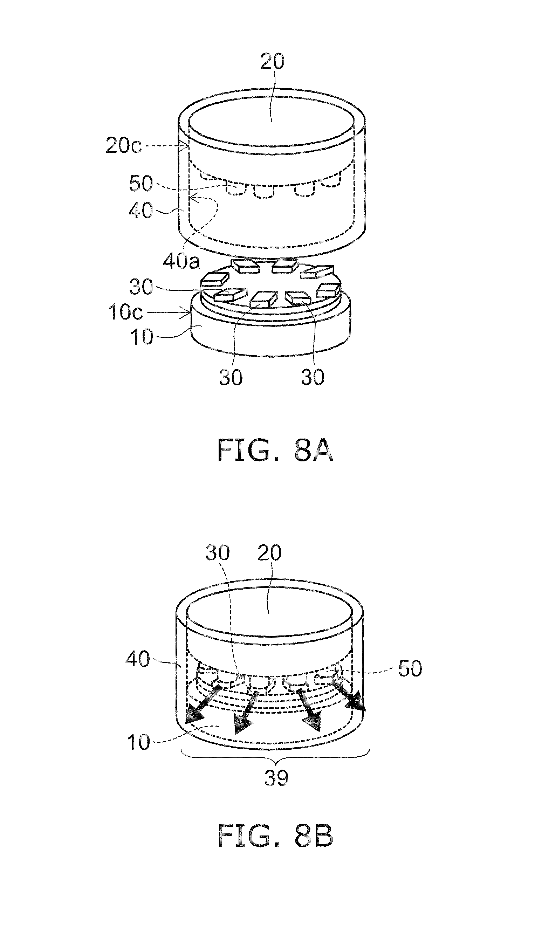

FIGS. 8A and 8B are schematic perspective views of a light emitting device according to a fifth embodiment.
In FIGS. 8A and 8B, eight light emitting elements 30 are placed along the outer periphery of the first plate electrode 10 at a spacing of 45 degrees. On the other hand, eight metal bumps 50 are placed along the outer periphery of the third major surface of the second plate electrode 20 at a spacing of 45 degrees. Furthermore, the outer edge 20c of the second plate electrode 20 and the inner edge 40a of the insulator 40 are tightly bonded.

Subsequently, as shown in FIG. 8B, with the eight light emitting elements 30 and the eight metal bumps 50 being evenly brought into contact with each other, the outer edge 10c of the first plate electrode 10 and the inner edge 40a of the insulator 40 are tightly bonded. This can realize a light emitting device capable of radially emitting light beams 39 in the horizontal plane.

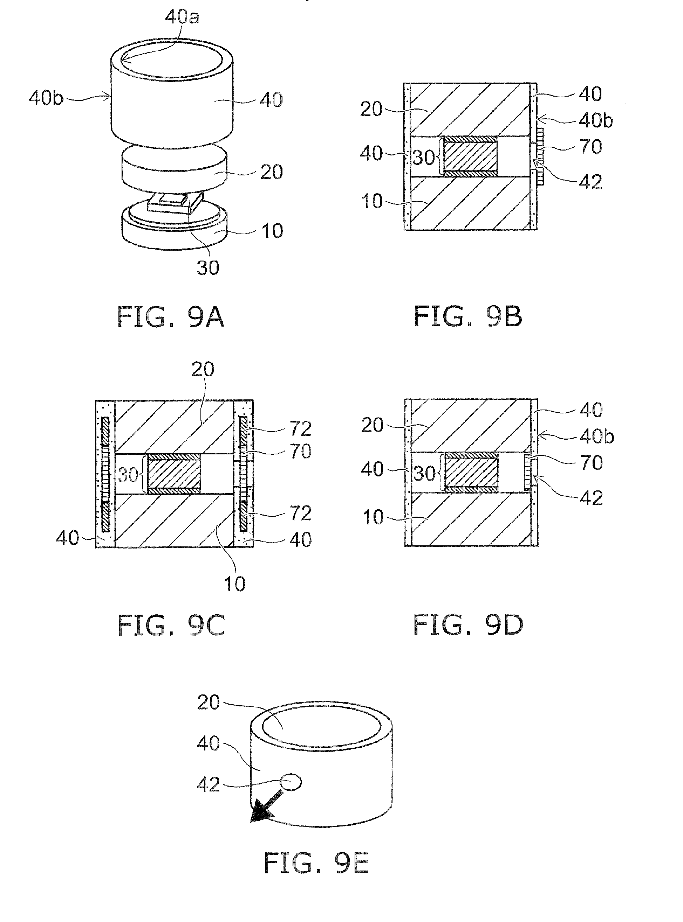

FIGS. 9A to 9E are schematic views of a light emitting device according to a sixth embodiment.
Phosphors 70 are arranged in one of the interior of the window 42 and the neighborhood of the window 42 of the insulator 40. FIG. 9A is a schematic perspective view before assembly. The phosphor 70 absorbs the light beam from the light emitting element 30 and emits light having a longer wavelength than the light beam. For instance, the wavelength of the light beam may be in the range from ultraviolet to blue light. The phosphors 70 may include red phosphors, green phosphors, and blue phosphors (in the case where the excitation light beam is ultraviolet light). Then, white light can be emitted as mixed light.

In FIG. 9B, the phosphors 70 are provided outside the window 42 provided in the insulator 40. In FIG. 9C, the phosphors 70 are provided in the interior of the insulator 40. In FIG. 9D, the phosphors 70 are provided inside the insulator 40. In these cases, the phosphors 70 are provided in contact with the insulator 40. That is, in the examples shown in FIGS. 9B and 9D, the phosphors 70 are provided adjacent to the window 42. For these small white light emission areas of the phosphors 70 excited by the light beam, even small optical components can easily focus light. The light emitting device shown in FIGS. 9B to 9D can be arranged on e.g. the side surface of a light guide plate to form a backlight source of an image display device. In this case, by rotating the light emitting device, the emission direction of the light beam can be easily changed.

As shown in FIG. 9E, the window 42 may be made small. This can suppress the generated mixed light returning from the small window 42 to the inside, and can increase the light extraction efficiency. Here, in the case where the excitation light is ultraviolet light, an ultraviolet reflecting film or ultraviolet absorbing film may be provided on the side surface of the insulator 40 except the window 42. This can suppress ultraviolet light emitting outside, and can protect the eyes.

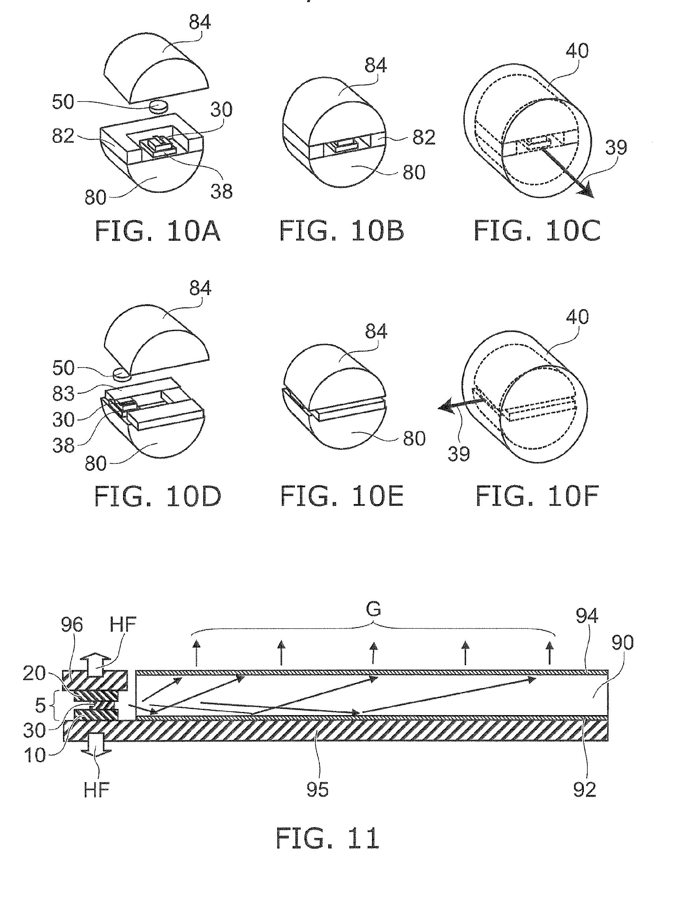

FIGS. 10A to 10F are schematic perspective views of a light emitting device according to a seventh embodiment.
In FIGS. 10A to 10C, the plate electrodes 80, 84 are shaped like a vertically cut cylindrical column. As shown in FIG. 10A, the light emitting element 30 is bonded to the first plate electrode 80. In this case, a submount 38 may be used. An insulator 82 is placed between the first and second plate electrodes 80, 84. The insulator 82 surrounds three side surfaces of the light emitting element 30 and includes an opening so as not to block the light beam 39 from the remaining side surface. Furthermore, a metal bump 50 is placed between one electrode of the light emitting element 30 and the second plate electrode 84. As shown in FIG. 10C, the outer edge of the first and second plate electrodes 80, 84 is bonded to the insulator (glass cap) 40. Then, the light beam 39 is emitted from between the first and second plate electrodes 80, 84 toward the upper surface of the glass cap.

In FIGS. 10D to 10F, the plate electrodes 80, 84 are shaped like a vertically cut cylindrical column. An insulator 83 is placed between the first and second plate electrodes 80, 84. The insulator 83 surrounds three side surfaces of the light emitting element 30 and includes an opening so as not to block the light beam 39 from the remaining side surface. The outer edge of the first and second plate electrodes 80, 84 is bonded to the insulator (glass cap) 40. Then, the light beam 39 is emitted from between the first and second plate electrodes 80, 84 toward the side surface of the glass cap. Here, the glass cap may include a window, and phosphors may be provided in at least one of the interior of the window and the neighborhood of the window.

The light emitting devices according to the first to seventh embodiments have improved heat conductivity, and hence facilitate increasing the brightness. Furthermore, they are easy to assemble on illumination devices and display devices. Moreover, the method for manufacturing has high mass productivity. As a result, the cost can be reduced.

FIG. 11 is a schematic sectional view of a linear light source using the light emitting device according to this embodiment.
The light output from the light emitting device 5 is incident into an end of a light guide plate 90 constituting the linear light source. A reflecting plate 92 is provided on the lower surface of the light guide plate 90. A light diffusing plate 94 is provided on the upper surface of the light guide plate 90. The light beam having a narrow full width at half maximum travels inside the light guide plate 90. While traveling, the light beam can be emitted upward from the light diffusing plate 94 as emission light G, and used as a linear light source.

If the light emitting device 5 may emit white light, the linear light source can be directly used as a backlight source of an image display device. Alternatively, the light beam from the light emitting device 5 can be used as excitation light, and phosphors can be provided above the light guide plate 90 to obtain white light. Thus, the linear light source can be used for e.g. a backlight source and automobile fog lamp.

In this embodiment, the first plate electrode 10 of the light emitting device 5 can be attached to a metal block 95. The second plate electrode 20 can be attached to a metal block 96. That is, the heat generated in the light emitting element 30 can escape through the heat conduction paths HF directed upward and downward. On the other hand, in a CAN package, thin leads serves as heat conduction paths. Thus, heat conductivity is too low to increase the brightness. In the illumination device and display device using the light emitting device according to this embodiment, the improved heat conductivity facilitates high current operation. Thus, while maintaining the reliability, high brightness can be achieved.

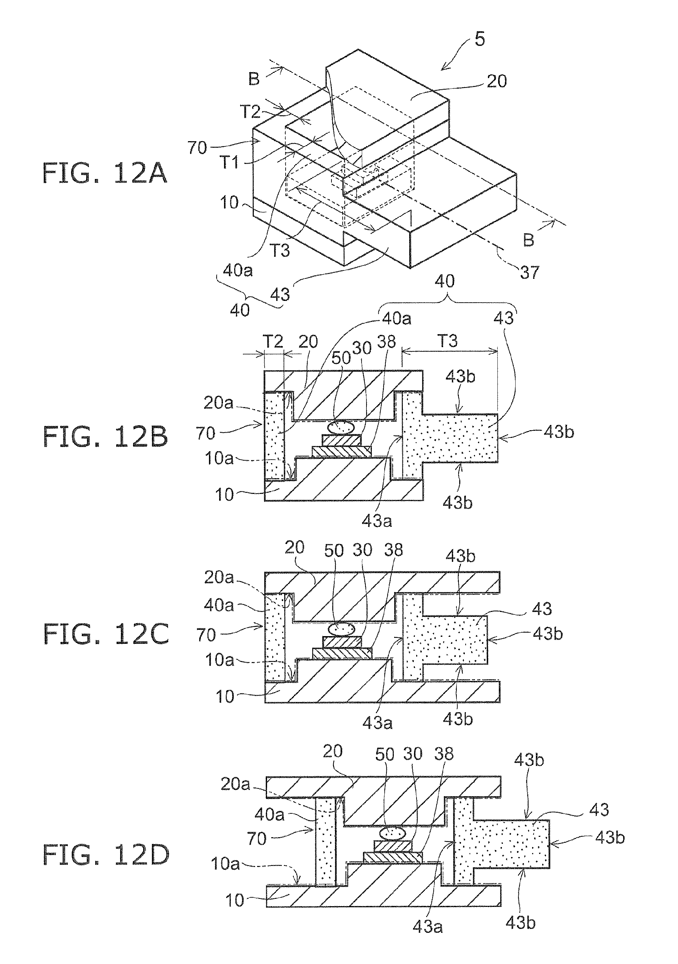

FIG. 12A is a schematic perspective view of a light emitting device according to an eighth embodiment. FIG. 12B is a schematic sectional view taken along line B-B. FIG. 12C is a schematic sectional view of a first variation. FIG. 12D is a schematic sectional view of a second variation.
FIG. 12A is a schematic perspective view in which part of the second plate electrode 20 is cut away. In the insulator 40, the window 43 is integrated with the portion 40a except the window. The thickness of the portion 40a except the window is set to e.g. T1 and T2, but may be a constant thickness (T1=T2). The thickness T3 of the window 43 is made larger than the thickness T1, T2 of the portion 40a except the window. The insulator 40 is sandwiched between the first major surface 10a of the first plate electrode 10 and the third major surface 20a of the second plate electrode 20 in contact therewith. The window 43 extends outward along the optical axis 37 direction.

The light beam from LD is approximated by a Gaussian beam having a full width at half maximum of approximately 15 degrees in the horizontal direction and approximately 30 degrees in the vertical direction. The distance between the end face of LD and the outer side surface 43b of the window 43 is set to e.g. 0.05 mm. The thickness T3 of the window 43 along the optical axis 37 of the light beam 39 is set to 4 mm. In this case, the full width at half maximum of the light beam 39 is spread to approximately 2.4 mm in the vertical direction and 1.2 mm in the horizontal direction at the outer side surface 43b of the window 43. Thus, the light density of the light beam 39 can be made lower at the outer side surface 43b of the window 43 than at the inner side surface 43a of the window 43. Here, the insulator 40 may be made of low melting point glass. This facilitates suppressing degradation (such as discoloration) due to the light beam.

In this case, the portion 40a except the window of the insulator 40 may scatter or block the light beam 39. This can suppress unnecessary emission of laser light to the outside. For instance, a light diffusing agent or phosphor particles for scattering laser light may be placed on the portion 40a except the window. Alternatively, a light blocking film may be provided on the outer side surface. Alternatively, a frost surface may be provided at the surface. Thus, the portion 40a except the window can function as a laser light blocking layer 70. Furthermore, as in the first variation of FIG. 12C and the second variation of FIG. 12D, the outer edge of the first plate electrode 10 or the outer edge of the second plate electrode 20 may be located at the outside of part of the insulator 40.

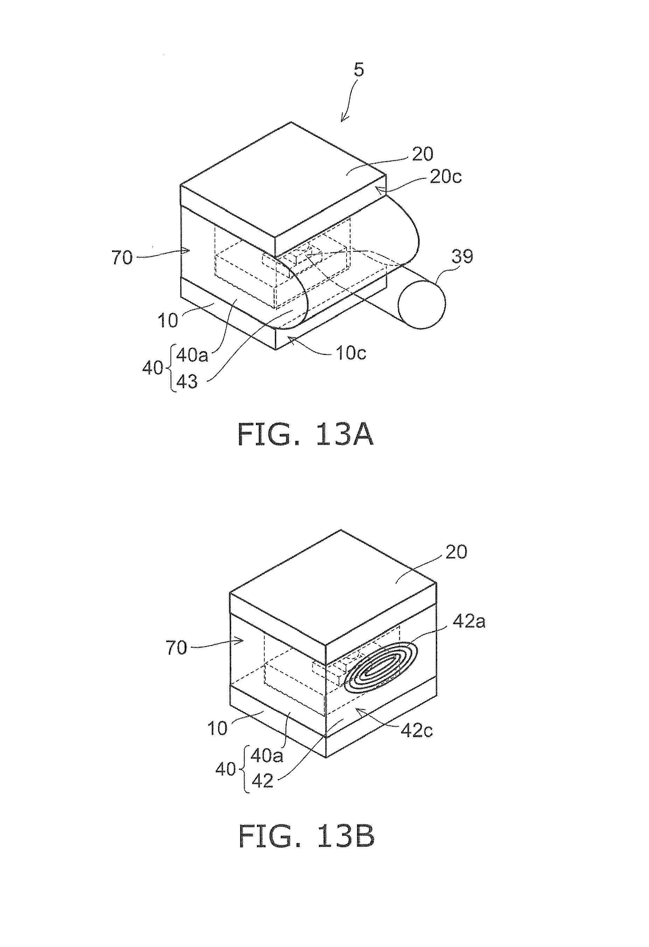

FIG. 13A is a schematic perspective view of a light emitting device according to a ninth embodiment. FIG. 13B is a schematic perspective view of a light emitting device according to a variation thereof.
In FIG. 13A, the window 43 can be a lens capable of collimating the light beam 39. In the light beam 39, the vertical angular divergence is larger than the horizontal angular divergence. Thus, for instance, a columnar lens having an outward convex vertical cross section such as a cylindrical lens facilitates collimating the light beam 39. This allows downsizing of e.g. light emitting illumination devices. Alternatively, an aspherical lens may be used.

Furthermore, as shown in FIG. 13B, a Fresnel lens pattern 42a may be provided at the outer side surface 42c of the window 42. This can also collimate the light beam.

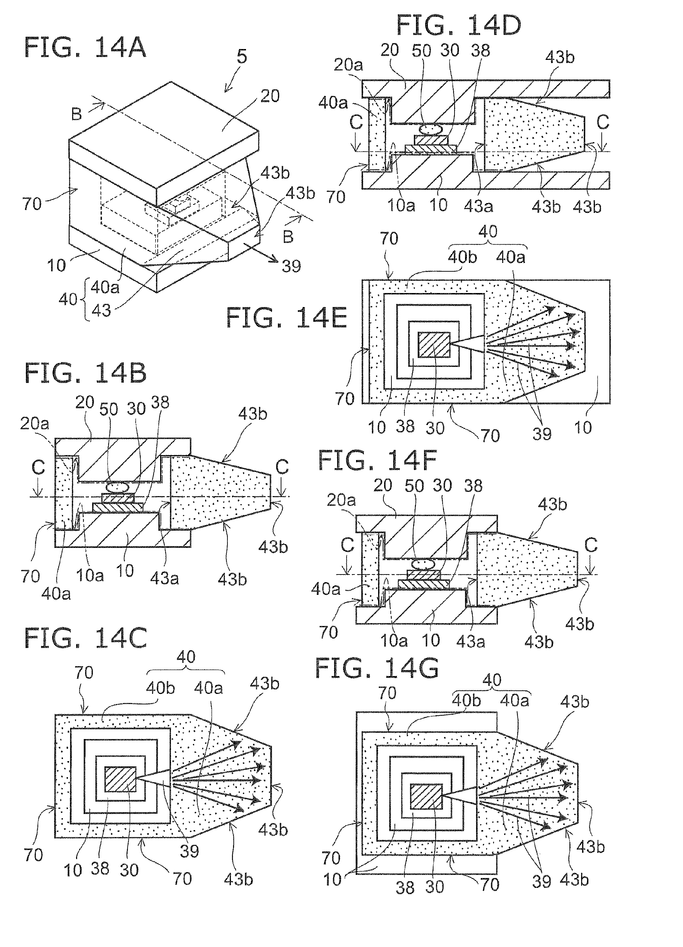

FIG. 14A is a schematic perspective view of a light emitting device according to a tenth embodiment. FIG. 14B is a schematic sectional view taken along line B-B. FIG. 14C is a schematic sectional view taken along line C-C. FIG. 14D is a schematic sectional view of a first variation thereof. FIG. 14E is a schematic sectional view of the first variation taken along line C-C. FIG. 14F is a schematic sectional view of a second variation. FIG. 14G is a schematic sectional view of the second variation taken along line C-C.
In the insulator 40, the window 43 is integrated with the portion 40a except the window. The insulator 40 is sandwiched between the first major surface 10a of the first plate electrode 10 and the third major surface 20a of the second plate electrode 20 in contact therewith. The side surface of the window 43 includes a tapered portion such that the cross-sectional area is narrowed outward. Thus, the light density of the light beam 39 can be made lower at the outer side surface 43b of the tapered portion of the window 43 than at the inner side surface 43a of the window 43. Furthermore, as in the first variation of FIGS. 14D and 14E and the second variation of FIGS. 14F and 14G, the outer edge of the first plate electrode 10 or the outer edge of the second plate electrode 20 may be located at the outside of part of the insulator 40.

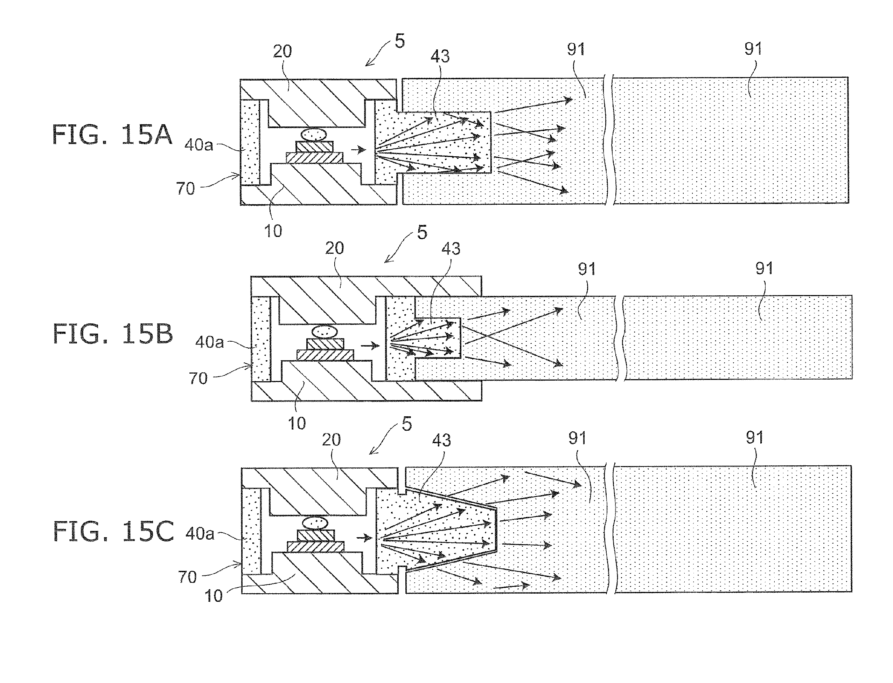

FIG. 15A is a schematic sectional view of a linear light emitting illumination device using the light emitting device according to the eighth embodiment. FIG. 15B is a schematic sectional view of a linear light emitting illumination device using the light emitting device according to the first variation of the eighth embodiment. FIG. 15C is a schematic sectional view of a linear light emitting illumination device using the light emitting device according to the tenth embodiment.
The light emitting device 5 of FIG. 15A is the light emitting device of the eighth embodiment of FIGS. 12A and 12B. The light emitting device 5 of FIG. 15B is the light emitting device of the tenth embodiment of FIGS. 14A and 14B. The window 43 has a rectangular cross section and is fitted into the recess provided in the light guide 91. In the case where the window 43 is in close contact with the recess, light with reduced light density is injected into the light guide 91 from the upper surface, the lower surface, and both side surfaces of the window 43.

The light emitting device 5 of FIG. 15C is the light emitting device of the tenth embodiment of FIG. 14B. In this case, a tapered portion is provided. Thus, even if a gap of e.g. air occurs between the window 43 and the surface of the recess provided in the light guide 91, light with reduced light density is injected more reliably into the light guide 91 from the surface of the tapered portion. In this case, the light density of the light beam 39 is sufficiently reduced. Thus, even if the light guide 91 is made of resin, degradation such as discoloration can be suppressed. Furthermore, this ensures sufficient optical coupling efficiency, and facilitates the cost reduction of the light emitting illumination device.

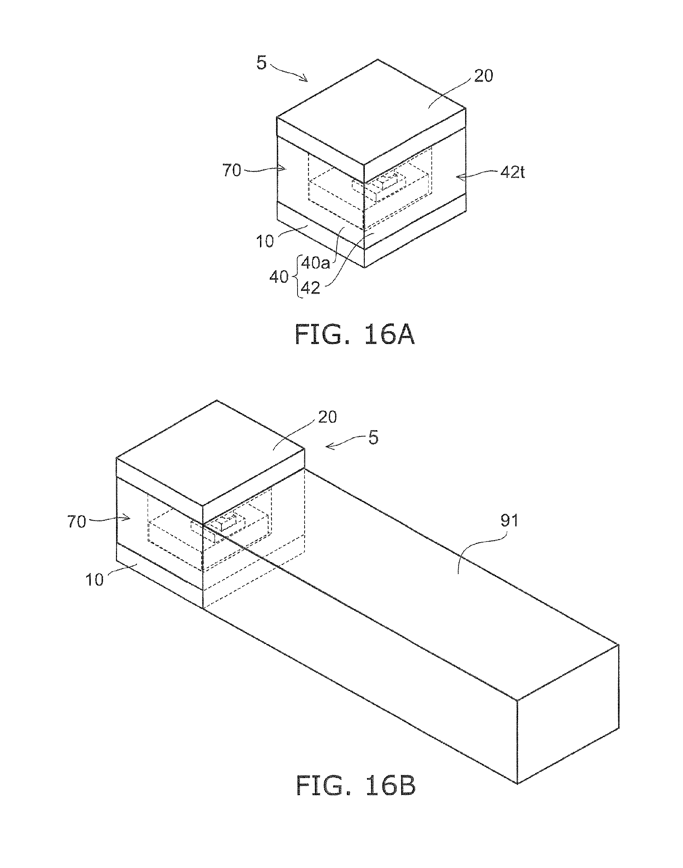

FIG. 16A is a schematic perspective view of a light emitting device according to an eleventh embodiment. FIG. 16B is a schematic perspective view of a linear light emitting illumination device.
The window portion 42 and the rest of the portion 40a are integrated as one frame-shape component. The portion 40a other than the window portion 42 can block or scatter the light return. This can reduce unnecessary radiation and enhance safety. The manufacturing process is simpler when only the surface 42t of the window 42 is made clear to keep transparency than when all of the side surfaces are made clear. In FIG. 16B, a laser light blocking layer 70 including e.g. phosphor particles is provided on the inner surface or the outer surface of the portion 40a except the window of the insulator 40 of the light emitting device 5. This can realize a linear light emitting illumination device in which the surface of the package of the light emitting device 5 can also emit light. In this case, the laser light blocking layer 70 of the insulator 40 can block or scatter the light beam. This facilitates ensuring safety.

The embodiments of the invention have been described above with reference to the drawings. However, the invention is not limited to these embodiments. The material, shape, size, layout and the like of the plate electrode, light emitting element, insulator, phosphor, metal bump and the like constituting the invention can be variously modified by those skilled in the art. Such modifications are also encompassed within the scope of the invention as long as they do not depart from the spirit of the invention.

### [Reference Signs List]

- 5: light emitting device
- 10, 80: first plate electrode
- 20, 84: second plate electrode
- 30: light emitting element
- 31: semiconductor stacked body
- 32: first electrode
- 34: second electrode
- 36: light emitting layer
- 37: optical axis
- 39: light beam
- 40, 44: insulator
- 42, 43: window
- 50: metal bump
- 70: phosphor

## Claims

1. A light emitting device comprising:
a first plate electrode including a first major surface and a second major surface on an opposite side of the first major surface;
a second plate electrode including a third major surface and a fourth major surface on an opposite side of the third major surface;
a light emitting element placed between the first major surface and the third major surface, the light emitting element including a semiconductor stacked body having a fifth major surface facing the first major surface and being smaller than the first major surface and a sixth major surface facing the third major surface and being smaller than the third major surface and including a light emitting layer, a first electrode provided on the fifth major surface and a second electrode provided on the sixth major surface, optical axis of a light beam emitted from the light emitting layer being made perpendicular to a side surface of the semiconductor stacked body between the fifth major surface and the sixth major surface; and
an insulator provided in contact with the first plate electrode and the second plate electrode and including a window formed on the optical axis,
the light beam being enabled to pass through the window and to be emitted outward.

2. The device according to claim 1, wherein
the insulator is sandwiched between the first major surface and the third major surface, and
thickness of the window along the optical axis is larger than thickness of the insulator except the window.

3. The device according to claim 1, wherein light density of the light beam is smaller at an outer side surface of the window than at an inner side surface of the window.

4. The device according to claim 1, wherein a Fresnel lens is provided at an outer side surface of the window.

5. The device according to claim 1, wherein
the insulator is made of glass,
the window has transparency, and
a portion of the insulator except the window has light blocking property or scatters the light beam.

6. The device according to claim 1, further comprising:
a phosphor provided in at least one of an interior of the window and a neighborhood of the window and being capable of absorbing the light beam from the light emitting element and emitting light having a longer wavelength than the light beam,
wherein emission light from the phosphor is enabled to pass through the window and to be emitted outward.

7. The device according to claim 1, further comprising:
a metal bump provided at least one of between the first electrode of the light emitting element and the first plate electrode and between the second electrode of the light emitting element and the second plate electrode.

8. The device according to claim 1, wherein the light emitting element is sealed by the insulator, the first plate electrode, and the second plate electrode.

9. The device according to claim 1, wherein a recess or a protrusion is provided on at least one of the second major surface of the first plate electrode and the fourth major surface of the second plate electrode.

## Amended claims

### Amended claims under Art. 19.1 PCT

**1.** (Amended) A light emitting device comprising:
a first plate electrode including a first major surface and a second major surface on an opposite side of the first major surface;
a second plate electrode including a third major surface and a fourth major surface on an opposite side of the third major surface;
a light emitting element placed between the first major surface and the third major surface, the light emitting element including a semiconductor stacked body having a fifth major surface facing the first major surface and being smaller than the first major surface and a sixth major surface facing the third major surface and being smaller than the third major surface and including a light emitting layer, a first electrode provided on the fifth major surface and a second electrode provided on the sixth major surface, optical axis of a light beam emitted from the light emitting layer being made perpendicular to a side surface of the semiconductor stacked body between the fifth major surface and the sixth major surface; and
an insulator bonded to the first plate electrode and the second plate electrode and including a window formed on the optical axis,
the light beam being enabled to pass through the window and to be emitted outward.

**2.** The device according to claim 1, wherein
the insulator is sandwiched between the first major surface and the third major surface, and
thickness of the window along the optical axis is larger than thickness of the insulator except the window.

**3.** The device according to claim 1, wherein light density of the light beam is smaller at an outer side surface of the window than at an inner side surface of the window.

**4.** The device according to claim 1, wherein a Fresnel lens is provided at an outer side surface of the window.

**5.** The device according to claim 1, wherein
the insulator is made of glass,
the window has transparency, and
a portion of the insulator except the window has light blocking property or scatters the light beam.

**6.** The device according to claim 1, further comprising:
a phosphor provided in at least one of an interior of the window and a neighborhood of the window and being capable of absorbing the light beam from the light emitting element and emitting light having a longer wavelength than the light beam,
wherein emission light from the phosphor is enabled to pass through the window and to be emitted outward.

**7.** The device according to claim 1, further comprising:
a metal bump provided at least one of between the first electrode of the light emitting element and the first plate electrode and between the second electrode of the light emitting element and the second plate electrode.

**8.** The device according to claim 1, wherein the light emitting element is sealed by the insulator, the first plate electrode, and the second plate electrode.

**9.** The device according to claim 1, wherein a recess or a protrusion is provided on at least one of the second major surface of the first plate electrode and the fourth major surface of the second plate electrode.

Statement under Art. 19.1 PCT
Claim 1 has made it clear that an insulator is bonded to a first plate electrode and a second plate electrode.

The matter to define the invention is based on the description in, for example, the paragraphs 0025, 0026, 0032 or the like of the specification.

In the document 1 cited in the international search report, insulative plate-like members (13A, 13B) are stacked between plate-like members (11, 15) made of conductive material, an optical waveguide (133) is provided on a surface portion of the insulative plate-like member 13A to reach side surfaces of the stacked insulative plate-like members (13A, 13B), a micro tile-like optical element (31) aligned to oppose the optical waveguide (133) is mounted on the side surfaces, the micro plate-like optical element (31) including pad electrodes (33A, 33B), the pad electrodes (33A, 33B) are connected to the side surfaces of the plate-like members (11, 15), respectively.

In the document 2, a nitride semiconductor laser element is sandwiched between a first submount (402) and a second submount (404) and bonded to a stem (406).

In the document 3, a light guide block (8) is disclosed, slant side surfaces (83) of the light guide block (8) being formed as slant planes opposing each other between an outer edge of a light emitting plane (84) and a lower end edge of an incident side surface (82).

According to the invention of claim 1 after the amendment, the insulator is bonded to the first plate electrode and the second plate electrode. This allows the insulator to support the first plate electrode and the second plate electrode.

More specifically, the insulator supports the first plate electrode and the second plate electrode mechanically, and this can keep reliable electrical connection, improve thermal conduction and protect a light emitting element, while relaxing an external force (paragraph 0032: thermal and mechanical stress) applied to the light emitting element sandwiched between the first plate electrode and the second plate electrode.
